Europäisches Patentamt

European Patent Office

Office européen des brevets

(19)

(11) **EP 1 230 828 B1**

(12) **FASCICULE DE BREVET EUROPEEN**

(45) Date de publication et mention
de la délivrance du brevet:
**03.11.2004 Bulletin 2004/45**

(21) Numéro de dépôt: **00979727.5**

(22) Date de dépôt: **14.11.2000**

(51) Int Cl.[7]: **H05G 2/00**

(86) Numéro de dépôt international:
**PCT/FR2000/003163**

(87) Numéro de publication internationale:
**WO 2001/037618 (25.05.2001 Gazette 2001/21)**

(54) **PROCEDE D'OBTENTION ET SOURCE DE RAYONNEMENT EXTREME ULTRAVIOLET, ET SON APPLICATION EN LITHOGRAPHIE**

VERFAHREN ZUR ERZEUGUNG EINER EXTREM-ULTRAVIOLETT-STRAHLUNGSQUELLE UND DEREN ANWENDUNG IN DER LITHOGRAPHIE

METHOD FOR OBTAINING AN EXTREME ULTRAVIOLET RADIATION SOURCE AND ITS USE IN LITHOGRAPHY

(84) Etats contractants désignés:
**AT BE CH CY DE DK ES FI FR GB GR IE IT LI LU MC NL PT SE TR**

(30) Priorité: **15.11.1999 FR 9914285**

(43) Date de publication de la demande:
**14.08.2002 Bulletin 2002/33**

(73) Titulaire: **COMMISSARIAT A L'ENERGIE ATOMIQUE**
**75752 Paris Cédex 15 (FR)**

(72) Inventeurs:
 • **BABONNEAU, Danièle**
   **F-91390 Morsang S/Orge (FR)**
 • **MARMORET, Rémy**
   **F-78320 Levis Saint Nom (FR)**
 • **BONNET, Laurence**
   **F-91310 Linas (FR)**

(74) Mandataire: **Weber, Etienne Nicolas et al**
   **c/o Brevalex,**
   **3, rue du Docteur Lancereaux**
   **75008 Paris (FR)**

(56) Documents cités:
**EP-A- 0 143 446**       **EP-A- 0 181 194**
**EP-A- 0 474 011**       **US-A- 4 504 964**
**US-A- 5 293 396**

• H.HIROSE ET AL.: "novel x-ray source using rear side x-ray emission from the foil target" PROG. CRYSTAL GROWTH AND CHARACT., vol. 33, 1996, page 277-280 XP000929483
• HANEY S J ET AL: "PROTOTYPE HIGH-SPEED TAPE TARGET TRANSPORT FOR A LASER PLASMA SOFT-X-RAY PROJECTION LITHOGRAPHY SOURCE" , APPLIED OPTICS,US,OPTICAL SOCIETY OF AMERICA,WASHINGTON, VOL. 32, NR. 34, PAGE(S) 6934-6937 XP000414599 ISSN: 0003-6935 page 6934 -page 6937
• K.EIDMANN ET AL.: "ABSOLUTELY MEASURED X-RAY SPECTRA FROM LASER PLASMAS WITH TARGETS OF DIFFERENT ELEMENTS" APPLIED PHYSICS LETTERS, vol. 49, no. 7, 18 août 1986 (1986-08-18), pages 377-378, XP002143275

EP 1 230 828 B1

## Description

## DOMAINE TECHNIQUE

La présente invention concerne un procédé d'obtention et une source de rayonnement extrême ultraviolet c'est-à-dire un rayonnement dans la bande ultraviolette extrême, que l'on appelle également « rayonnement EUV ».

Il s'agit d'un rayonnement dont la longueur d'onde est comprise dans le domaine allant de 8 nanomètres à 25 nanomètres.

La présente invention a de nombreuses applications notamment en science des matériaux, en microscopie et tout particulièrement en lithographie.

La présente invention concerne aussi un dispositif de lithographie utilisant la source de rayonnement EUV objet de l'invention.

L'utilisation d'un tel rayonnement permet de diminuer le pas de gravure des circuits intégrés et donc de fabriquer des circuits intégrés à très haut degré d'intégration.

## ÉTAT DE LA TECHNIQUE ANTÉRIEURE

On rappelle qu'un dispositif de lithographie est destiné à insoler un échantillon suivant un motif (« pattern ») déterminé. Cet échantillon comprend en général un substrat semiconducteur sur lequel est déposée une couche de résine photosensible (« photoresistive layer ») qui est destinée à être insolée suivant le motif déterminé.

Un dispositif de lithographie comprend :

- une source de rayonnement d'insolation,
- un masque sur lequel est reproduit le motif à insoler avec un facteur d'aggrandissement au moins égal à quatre,
- un support d'échantillon, et
- des moyens optiques qui permettent le transport du rayonnement d'une part entre la source et le masque et d'autre part entre le masque et l'échantillon.

On connaît principalement deux techniques de production d'un rayonnement EUV intense. Elles reposent toutes deux sur la collection des photons produits, grâce au processus microscopique d'émission spontanée, par un plasma chaud et peu dense qui est engendré au moyen d'un laser.

La première technique utilise un jet de xénon irradié par un laser YAG dont la puissance est voisine de 1 kW. En effet, lorsque la nature du gaz et les conditions de détente dans le vide (« vacuum ») sont bien choisies, il se crée naturellement dans le jet, par interaction de plusieurs corps, des agrégats (« clusters »). Ce sont des macro-particules qui peuvent contenir jusqu'à un million d'atomes et présentent une densité suffisamment élevée (environ un dixième de la densité du solide) pour absorber le faisceau laser et chauffer ainsi les atomes du gaz environnant qui peuvent alors, par fluorescence, émettre des photons.

Le rayonnement EUV, ou rayonnement X mou, ainsi obtenu est collecté par des moyens optiques appropriés, est mis en forme spatialement à l'aide de plusieurs moyens optiques intermédiaires et irradie ensuite le masque. Les moyens optiques intermédiaires utilisés sont des miroirs multicouches qui présentent un pic de réflectivité au voisinage de la longueur d'onde EUV recherchée élevé mais étroit (2 à 5% de bande passante suivant les multicouches considérées). Par exemple: 13,4 nm avec une alternance de couches de Mo et de couches de Si et 11,2 nm avec une alternance de couches de Mo et de couches de Be.

La deuxième technique utilise la couronne d'un plasma de numéro atomique élevé, obtenu par interaction d'un faisceau laser, qui provient d'un laser KrF et dont l'intensité est voisine de $10^{12}$ W/cm$^2$, et d'une cible solide de forte épaisseur (au moins 20 µm).

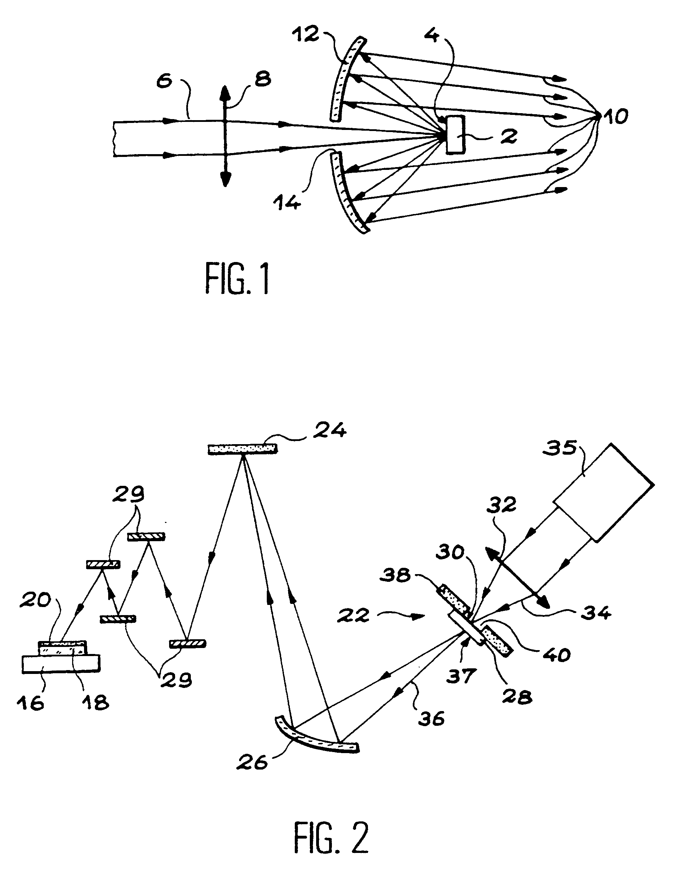

Ceci est schématiquement illustré par la figure 1 où l'on voit cette cible solide 2 sur une face 4 de laquelle est focalisé le faisceau laser 6 par l'intermédiaire de moyens optiques de focalisation appropriés 8. On voit également sur la figure 1 le rayonnement EUV 10 engendré par interaction du faisceau laser focalisé et du matériau de la cible. Ce rayonnement est émis à partir de la face 4 appelée « face avant » et récupéré par des moyens optiques de collection appropriés 12.

Dans l'exemple représenté, ces moyens optiques de collection 12 sont disposés en regard de la face avant 4. Ils comportent une ouverture 14 permettant le passage du faisceau laser focalisé et collectent le rayonnement EUV 10 pour l'envoyer vers d'autres moyens optiques (non représentés) afin d'utiliser ce rayonnement EUV. Le matériau le plus adapté à ce genre de source semble être le rhénium pour une émission au voisinage de 13,4 nm. Le taux de conversion obtenu avec ce matériau (rapport entre l'énergie radiative émise et l'énergie incidente) peut même atteindre 0,85% dans une bande passante de 2% autour de cette longueur d'onde de 13,4 nm.

Cependant, l'énergie d'une telle source de rayonnement EUV est insuffisante car l'énergie laser, dans le cas des expériences citées, est seulement de l'ordre de 1J à quelques joules.

Mais c'est surtout l'efficacité de collection des photons qui est faible (de l'ordre de 10%) et qui fait que, au total, le rendement de l'énergie des photons utilisable rapportée à l'énergie laser) est trop faible. De plus, la détente de la cible est importante de sorte que des dispositifs spécifiques doivent être conçus pour éloigner des moyens optiques de collection les particules émises par la cible lors de l'interaction du faisceau laser et de la cible.

Les difficultés mentionnées ci-dessus résultent de la nature du processus physique utilisé, à savoir l'émission par fluorescence d'un milieu chaud et peu dense. En effet, lorsqu'on excite un électron lié au sein d'un atome ou d'un ion multichargé, par un processus mettant en jeu soit un photon (mécanisme radiatif) soit un électron (mécanisme collisionnel), cet atome ou cet ion se retrouve dans un état excité qui n'est pas stable. Il peut alors se désexciter en émettant un ou plusieurs photons.

Pour obtenir un photon ayant une longueur d'onde précise (à la largeur de la transition près), il suffit donc de créer un ion multichargé adéquat au sein duquel des transitions d'énergie correspondant à l'énergie du photon cherché existent. Il convient de noter que lorsque le photon est émis par émission spontanée, il ne possède pas de direction privilégiée : l'émission du rayonnement est isotrope.

L'une des techniques les mieux adaptées à la création d'un grand nombre d'ions multichargés excités utilise l'interaction d'un faisceau laser de puissance et d'un milieu de forte densité. En effet, lorsqu'un faisceau laser de puissance interagit avec une cible solide (ou presque solide), l'onde électromagnétique associée au faisceau laser se propage dans le milieu jusqu'à une densité dite de coupure (qui est inversement proportionnelle à $\lambda^2$, où $\lambda$ est la longueur d'onde du laser) et transfère son énergie à ce milieu par le biais de plusieurs processus microscopiques.

Des électrons liés sont alors susceptibles d'être arrachés aux atomes, d'être accélérés par le champ électrique engendré par le laser et d'acquérir une énergie cinétique suffisante pour, à leur tour, arracher d'autres électrons liés. On crée ainsi des ions multichargés; la température du milieu augmente rapidement jusqu'à atteindre des valeurs extrêmes (plusieurs centaines de milliers voire plusieurs millions de degrés) et des processus microscopiques conduisant à l'émission de photons peuvent avoir lieu. En effet, sous l'action du champ laser le milieu se transforme en plasma constitué d'ions multichargés, d'électrons et de photons.

A l'exception de conditions particulières de densité, de température et/ou de champ de rayonnement, les différentes espèces mentionnées ci-dessus ne sont pas à l'équilibre entre elles. On observe notamment cela dans la couronne d'un plasma qui correspond à la zone de détente où l'onde électromagnétique du laser se propage et interagit fortement avec le milieu. Cette couronne est caractérisée par une faible densité de matière (inférieure à 0,001 fois la densité du solide) et une température élevée. La probabilité qu'un photon émis dans la couronne y soit réabsorbé est extrêmement faible: cette couronne est dite optiquement mince.

Les photons émis quittent le plasma et peuvent alors être utilisés à des fins diverses, par exemple pour un diagnostic des conditions thermodynamiques du milieu par spectroscopie ou pour une lithographie.

Les inconvénients des sources connues de rayonnement EUV, sont décrits ci-dessous :

Ces sources présentent un problème d'efficacité : des conditions thermodynamiques (densité, température, nombre d'électrons libres) très variées se rencontrent dans la couronne d'un plasma engendré par laser aussi bien au cours du temps que dans l'espace.

Le spectre caractéristique d'émission de rayonnement d'une couronne au voisinage de 10 nm est très complexe et comprend de nombreuses raies d'émission provenant d'émission atomique ou d'états de charge différents. Lorsque l'on sélectionne une raie bien précise avec une bande passante très étroite (de l'ordre de 2%), on constate qu'une grande partie de l'énergie émise par le plasma sous forme de rayonnement se trouve en dehors de cette bande passante et se trouve donc perdue.

L'efficacité (rapport de l'énergie EUV produite et utilisée sur l'énergie laser utilisée) est par conséquent fortement réduite. De plus, un rayonnement « parasite » est émis de façon isotrope, en particulier dans l'angle solide de collection des photons utiles et donc vers les moyens optiques de collection de ces photons.

En ce qui concerne la collection du rayonnement EUV, l'émission de photons par un jet chaud étant isotrope, des moyens optiques de collection appropriés doivent être prévus. On utilise en général un collecteur optique en forme de parapluie, obtenu par juxtaposition de collecteurs optiques élémentaires (en général au nombre de six). Afin que son angle solide soit maximum, ce collecteur doit présenter une grande superficie et doit être placé le plus près possible du plasma qui émet le rayonnement EUV.

Ceci est matériellement très difficile (notamment dans le cas d'une utilisation d'agrégats de xénon à cause de la présence d'une buse et d'un système de récupération du xénon). Cela pose aussi des problèmes en terme de durée de vie du collecteur et de la réalisation de ce dernier. Il convient donc d'éloigner ce collecteur de la source de rayonnement EUV, ce qui a pour conséquence de diminuer alors l'angle de collection (à moins de former un collecteur gigantesque dont le coût serait prohibitif). Il en résulte donc une perte d'efficacité.

Les mêmes problèmes se posent dans le cas de l'utilisation d'une cible solide où le rayonnement EUV est émis par la face avant de cette cible. De plus, dans ce cas, la couronne de plasma engendrée par le laser possède, même pour un éclairement laser modéré, une très forte vitesse de détente (supérieure à $10^6$ cm/s). Des particules de matière sont donc susceptibles de polluer et d'endommager les diverses optiques utilisées, d'où un risque de diminution des propriétés de réflexion de ces optiques et donc du nombre de photons qui parviennent à la couche de résine photosensible que l'on souhaite insoler. Il faut alors concevoir des dispositifs spécifiques, destinés à éliminer ces particules ou débris.

De plus, l'émission par fluorescence d'un plasma chaud et peu dense n'ayant pas de direction privilégiée, il faut insérer des moyens optiques spécifiques entre le collecteur et le masque afin de mettre spatialement en forme le champ d'irradiation. Ces moyens optiques spécifiques sont constitués de miroirs multicouches et conduisent donc à une perte de photons. Ils sont aussi une cause supplémentaire de coût et de difficulté d'alignement optique.

Une source de rayonnement EUV utilisant une cible solide épaisse, qui émet le rayonnement EUV par la face avant, face qui reçoit le faisceau laser focalisé, présente ainsi divers inconvénients, à savoir l'émission de débris et l'émission isotrope d'un rayonnement EUV ayant donc une grande divergence angulaire. Il en résulte en particulier qu'un dispositif de lithographie utilisant une telle source est peu efficace.

Les documents suivants divulguent des techniques connues, relatives à l'émission de rayonnements X ou EUV :

- H. Hirose et al., Prog. Crystal Growth and Charact., vol.33, 1996, pages 277-280, divulgue une source de rayons X utilisant une émission de rayons X par la face arrière d'une cible;

- S.J. Haney et al., Applied Optics, vol. 32, n° 34, 1993, pages 6934 à 6937, divulgue un système de transport rapide d'une cible en forme de bande pour la production de rayons X mous pour la lithographie;

- US 5 293 396 A (T. Tomie) divulgue un générateur de plasma pour un laser EUV;

- K. Eidman et al., Applied Physics Letters, vol. 49, n° 7, 1986, pages 377 et 378, divulgue des spectres de rayons X mesurés de façon absolue et issus de plasmas obtenus à partir de cibles de divers éléments;

- EP 0 474 011 A (Shimadzu Corporation) divulgue un procédé et un dispositif de génération de rayons X.

**EXPOSÉ DE L'INVENTION**

La présente invention définie dans les revendications 1 et 2 a pour but de remédier aux inconvénients précédents en proposant une source de rayonnement EUV anisotrope. Ce rayonnement EUV (par exemple destiné à être utilisé dans un dispositif de lithographie) est émis par la face arrière d'une cible solide d'épaisseur appropriée sur la face avant de laquelle est focalisé le faisceau laser.

Une telle source anisotrope permet d'augmenter la partie utile du faisceau de rayonnement EUV et de simplifier les moyens optiques de collection de ce rayonnement. étant

De façon précise, la présente invention a pour objet un procédé d'obtention de rayonnement extrême ultraviolet, procédé selon lequel on utilise au moins une cible solide, ayant une première et une seconde faces, cette cible étant capable d'émettre un rayonnement extrême ultraviolet par interaction avec un faisceau laser, et on focalise le faisceau laser sur la première face de la cible, procédé caractérisé en ce que la cible contient un matériau qui est apte à émettre le rayonnement extrême ultraviolet par interaction avec le faisceau laser, et en ce que l'épaisseur de la cible est comprise dans un intervalle allant d'environ 0,05 µm à environ 5 µm, la cible étant apte à émettre, de façon anisotrope, une partie du rayonnement extrême ultraviolet à partir de la deuxième face de cette cible, et en ce qu'on collecte et on transmet cette partie du rayonnement extrême ultraviolet en vue d'une utilisation de cette partie.

L'invention a également pour objet une source de rayonnement extrême ultraviolet, cette source comprenant au moins une cible solide, ayant des première et deuxième faces, cette cible étant apte à émettre un rayonnement extrême ultraviolet par interaction avec un faisceau laser focalisé sur la première face de la cible, cette source étant caractérisée en ce que la cible contient un matériau qui est apte à émettre le rayonnement extrême ultraviolet par interaction avec le faisceau laser, et en ce que l'épaisseur de la cible est comprise dans un intervalle allant d'environ 0,05 µm à environ 5 µm, la cible étant apte à émettre, de façon anisotrope, une partie du rayonnement extrême ultraviolet à partir de la deuxième face de cette cible, cette partie du rayonnement extrême ultraviolet étant collectée et transmise en vue d'une utilisation de cette partie.

De préférence, le numéro atomique du matériau contenu dans la cible appartient à l'ensemble des numéros atomiques allant de 28 à 92.

Selon un mode de réalisation particulier de la source objet de l'invention, cette source comprend une pluralité de cibles qui sont rendues solidaires les unes des autres, la source comprenant en outre des moyens de déplacement de cette pluralité de cibles pour que ces cibles reçoivent successivement le faisceau laser.

La source peut comprendre en outre des moyens de support auxquels sont fixées les cibles et qui sont aptes à laisser passer le faisceau laser en direction de ces cibles, les moyens de déplacement étant prévus pour déplacer ces moyens de support et donc les cibles.

Ces moyens de support peuvent être aptes à absorber des rayonnements émis par la première face de chaque cible qui reçoit le faisceau laser et à réémettre ces rayonnements vers cette cible.

Selon un premier mode de réalisation particulier de la source objet de l'invention, les moyens de support comprennent une ouverture en regard de chaque cible, cette ouverture étant délimitée par deux parois sensiblement parallèles l'une à l'autre et perpendiculaires à cette cible.

Selon un deuxième mode de réalisation particulier, les moyens de support comprennent une ouverture en regard de chaque cible, cette ouverture étant délimitée par deux parois qui vont vers la cible en s'écartant l'une de l'autre.

Selon un mode de réalisation particulier de l'invention, la source comprend en outre des moyens auxiliaires fixes qui sont aptes à laisser passer le faisceau laser en direction de la cible, à absorber des rayonnements émis par la première face de cette cible et à réémettre ces rayonnements vers cette cible.

La présente invention a également pour objet un dispositif de lithographie comprenant :

- un support d'un échantillon qui est destiné à être insolé suivant un motif déterminé,
- une source de rayonnement extrême ultraviolet conforme à l'invention,
- un masque comprenant le motif déterminé sous une forme agrandie,
- des moyens optiques de collection et de transmission, au masque, de la partie du rayonnement extrême ultraviolet provenant de la deuxième face de la cible de la source, le masque étant ainsi apte à fournir une image du motif sous forme agrandie, et
- des moyens optiques de réduction de cette image et de projection de l'image réduite sur l'échantillon.

L'échantillon peut comprendre un substrat semiconducteur sur lequel est déposée une couche de résine photosensible qui est destinée à être insolée suivant le motif déterminé.

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

- la figure 1 est une vue schématique d'une source connue de rayonnement EUV et a déjà été décrite,
- la figure 2 est une vue schématique d'un mode de réalisation particulier du dispositif de lithographie objet de l'invention qui utilise une source de rayonnement EUV conforme à l'invention,
- la figure 3 est une vue en perspective schématique d'un ruban formant un ensemble de cibles qui sont utilisables dans l'invention,
- les figures 4 et 5 sont des vues en perspectives schématiques et partielles de sources de rayonnement EUV conformes à l'invention, et
- la figure 6 est une vue en perspective schématique et partielle d'une autre source de rayonnement EUV conforme à l'invention.

## EXPOSÉ DÉTAILLÉ DE MODES DE RÉALISATION PARTICULIERS

Un plasma créé par interaction d'une cible solide et d'un faisceau laser comporte plusieurs zones. Il y a certes la zone d'interaction que l'on appelle « la couronne » mais il y a aussi, de façon successive et simplifiée :

- une zone appelée « zone de conduction » où le faisceau laser ne pénètre pas et dont l'évolution est commandée par les conductions thermique, électronique et radiative, une partie des photons émis par les ions de la couronne étant émise en direction de la partie froide et dense de la cible; et
- la zone d'absorption et de ré-émission où les photons d'énergies élevées, qui arrivent de la couronne ou de la zone de conduction, sont absorbés par la matière dense et froide et contribuent ainsi au chauffage de cette matière et donc à l'émission de photons d'énergies inférieures.

Ces derniers forment une onde radiative qui possède, dans le milieu, une direction privilégiée de propagation, le long du gradient de température et qui peut, lorsque la cible n'est pas trop épaisse, sortir de la cible par la face arrière de celle-ci, face qui est géométriquement opposée à celle où le laser a interagi. L'efficacité de conversion en la face arrière (rapport entre l'énergie radiative, toutes longueurs d'onde comprises, à l'énergie laser incidente) peut être voisine de 30%.

Cette émission à partir de la face arrière de la cible se caractérise par une distribution spectrale très différente de celle de la face avant car les conditions de température et de densité des zones responsables de l'émission de photons sont très différentes. Le rayonnement émis possède naturellement une distribution angulaire, même avec une cible parfaitement plane : ce rayonnement n'est pas isotrope.

De plus, la vitesse caractéristique de détente de la face arrière est inférieure, de plusieurs ordres de grandeur, à celle de la face avant, la majorité de l'énergie étant sous forme de rayonnement.

Ainsi utilise-t-on, dans la présente invention, le rayonnement EUV émis par la face arrière d'une cible solide d'épaisseur appropriée, sur la face avant de laquelle on focalise le faisceau laser. On obtient de cette façon un rayonnement EUV anisotrope et l'on réduit au minimum les débris de matière.

Pour engendrer le rayonnement EUV, la cible contient, de préférence, un matériau dont le numéro atomique Z est tel que $28 \leq Z \leq 92$.

On peut mélanger ou associer à ce matériau d'autres matériaux également aptes à engendrer, par interaction avec le faisceau laser, un rayonnement EUV possédant les bonnes caractéristiques spectrales.

En outre, on peut éventuellement lui associer un ou plusieurs autres matériaux de faibles numéros atomiques, destinés à filtrer un rayonnement parasite.

L'épaisseur de la cible, contenant le matériau générateur de rayonnement EUV, dit encore élément actif, est de préférence comprise entre 0,1 $\mu$m et 5 $\mu$m.

De préférence, on optimise la cible pour obtenir une émission efficace par la face arrière, sans que la détente de la matière soit trop importante.

On adapte aussi les caractéristiques du laser (en particulier la durée et la forme temporelle des impulsions lumineuses qu'il fournit, la longueur d'onde et l'intensité) à l'obtention des conditions thermodynamiques requises dans la cible pour une conversion EUV optimale en la face arrière dans la gamme de longueurs d'onde souhaitée qui va par exemple de 10 nanomètres à 20 nanomètres.

Sur la figure 2, on a représenté schématiquement un mode de réalisation particulier de la source de rayonnement EUV objet de l'invention dans une application particulière à la lithographie.

On voit donc sur cette figure 2, de façon schématique, un dispositif de lithographie comprenant un support 16 d'un substrat semiconducteur 18, par exemple un substrat de silicium, sur lequel est déposée une couche 20 de résine photosensible, destinée à être insolée suivant un motif déterminé.

Outre la source 22 de rayonnement EUV conforme à l'invention, le dispositif comprend :

- un masque 24, comprenant le motif sous une forme agrandie,
- des moyens optiques 26 de collection et de transmission, au masque 24, de la partie de rayonnement EUV fournie par la face arrière de la cible solide 28 que comporte la source, le masque 24 fournissant une image de ce motif sous forme agrandie, et
- des moyens optiques 29 de réduction de cette image et de projection de l'image réduite sur la couche 20 de résine photosensible.

La cible est par exemple faite d'un matériau tel que l'argent, le cuivre, le samarium ou le rhénium et a une faible épaisseur (par exemple de l'ordre de 1 μm).

Pour engendrer le rayonnement EUV destiné à insoler la couche de résine photosensible, on focalise sur une première face 30 de la cible, appelée « face avant », par l'intermédiaire de moyens optiques de focalisation 32, un faisceau pulsé 34 émis par un laser pulsé 35. La cible 28 émet alors un rayonnement EUV anisotrope 36 à partir de sa face arrière 37 qui est opposée à la face avant 30.

On précise que la source 22, le collecteur 26, le masque 24, les moyens optiques 29 et le support 16 portant le substrat 20 sont placés dans une enceinte (non représentée) où l'on établit une basse pression. Le faisceau laser est envoyé dans cette enceinte à travers un hublot approprié (non représenté).

Dans l'exemple de la figure 2, les moyens optiques de collection 26 consistent en un collecteur optique qui est disposé en regard de la face arrière 37 de la cible 28, prévu pour collecter le rayonnement EUV émis de façon anisotrope par cette face arrière, mettre en forme ce rayonnement et l'envoyer vers le masque 24.

Dans le dispositif de la figure 2, il n'est donc pas nécessaire de prévoir des moyens optiques supplémentaires entre le collecteur 26 et le masque 34, d'où une simplification des moyens optiques du dispositif de lithographie.

On voit que la cible de faible épaisseur 28 est fixée par sa face avant 30 à un support 38 pourvu d'une ouverture 40 permettant le passage du faisceau laser focalisé 34 pour que celui atteigne cette face avant.

En pratique, étant donné qu'une impulsion laser détruit localement la cible de faible épaisseur, on ne peut pas envoyer deux fois le faisceau laser au même endroit de la cible. C'est pourquoi on munit le support 38 de moyens de déplacement (non représentés sur la figure 2) permettant d'exposer successivement différentes zones de la cible au faisceau laser focalisé.

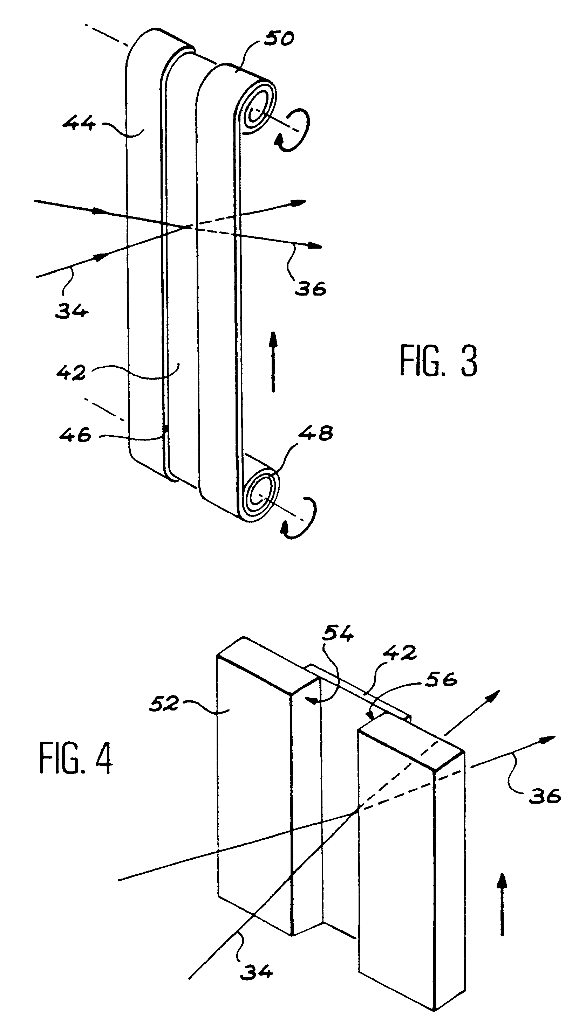

Ceci est schématiquement illustré par la figure 3 où l'on voit une cible solide 42 de faible épaisseur (par exemple 1 μm) sous la forme d'un ruban fixé à un support souple 44, qui est par exemple en matière plastique, et pourvu d'une ouverture longitudinale 46 pour laisser passer le faisceau laser focalisé 34.

L'ensemble cible-support forme un ruban composite souple qui est déroulé à partir d'une première bobine 48 et s'enroule sur une deuxième bobine 50 susceptible d'être mise en rotation par des moyens appropriés (non représentés), ce qui permet de déplacer la cible en regard du faisceau laser focalisé dont les impulsions atteignent successivement différentes zones de la cible. On peut alors considérer qu'on a plusieurs cibles assemblées les unes aux autres.

Dans une variante (non représentée), on peut encore utiliser un ruban souple en matière plastique en tant que support de cible et fixer plusieurs cibles à intervalles réguliers sur ce support, une ouverture étant alors prévue dans le support en regard de chaque cible pour laisser passer le faisceau focalisé.

De préférence, au lieu d'un ruban en matière plastique, on utilise, en tant que support de cible, un ruban 52 (figure 4) par exemple en cuivre, en argent, en samarium ou en rhénium, apte à absorber le ou les rayonnements émis par la face avant de la cible 42 sous l'impact du faisceau focalisé 34 et à ré-émettre ce ou ces rayonnements en direction de cette cible (qui est mobile avec le ruban 52). Ce ruban 52 a par exemple une épaisseur de l'ordre de 5 μm à 10 μm.

L'ouverture longitudinale permettant le passage du faisceau laser 34 qui est focalisé sur la cible peut être délimitée par deux parois 54 et 56 sensiblement parallèles l'une à l'autre et sensiblement perpendiculaires à la cible comme on le voit sur la figure 4.

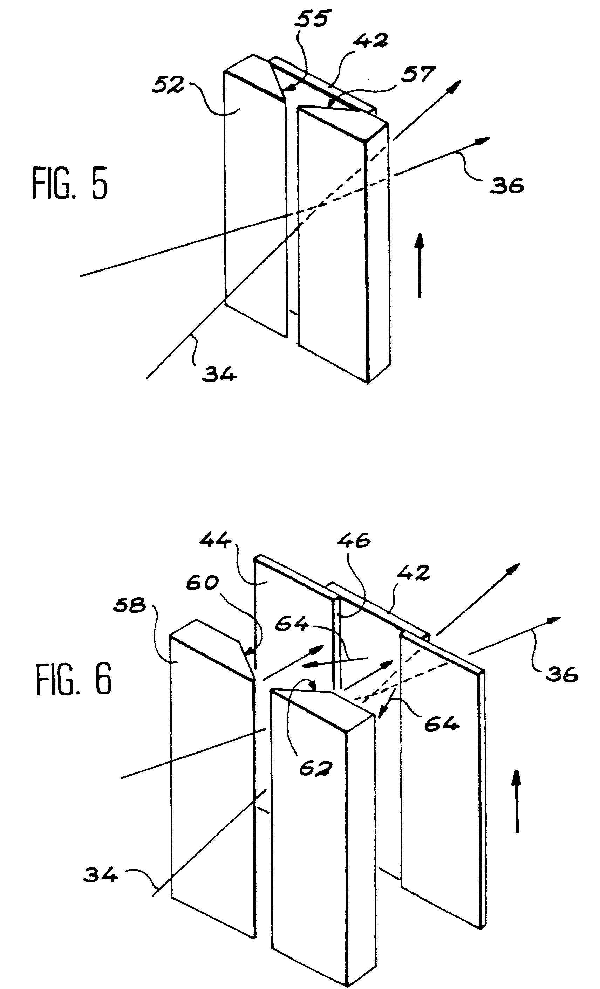

Cependant, pour une meilleure absorption du ou des rayonnements émis par la face avant de la cible et une meilleure ré-émission de ceux-ci vers la cible, il est préférable que les deux parois 55 et 57 délimitant l'ouverture aillent en s'écartant l'une de l'autre vers la cible comme on le voit sur la figure 5.

Dans un autre exemple schématiquement représenté sur la figure 6, la cible 42 est fixée à un support mobile 44 du genre de celui qui a été décrit en faisant référence à la figure 3. De plus, dans l'exemple de la figure 6, la source de rayonnement EUV comprend une pièce 58 fixe par rapport au faisceau laser focalisé 34 et disposée en regard de la face avant de la cible.

Cette pièce comprend une ouverture permettant le passage du faisceau laser que l'on focalise sur cette face avant de la cible et l'ouverture dont est pourvue cette pièce va en s'évasant vers la cible et comprend donc deux parois 60 et 62 inclinées par rapport à cette cible et allant en s'éloignant l'une de l'autre vers la cible.

Le ou les rayonnements 64 émis par la face avant de la cible 42 sont alors absorbés par ces parois 60 et 62 et ré-émis en direction de la face-avant de la cible.

Le rayonnement EUV 36 émis par la face arrière de la cible est ainsi plus intense.

Certes, on connaît par un article de H. Hirose et al., Prog. Crystal Growth and Charact., vol. 33, 1996, pp. 277-280, une source de rayons X utilisant une émission de rayons X par la face arrière d'une cible formée par une feuille d'aluminium dont l'épaisseur vaut 7 µm et dont la face avant est irradiée par un faisceau laser, avec une densité de puissance de 3 x $10^{13}$ W/cm$^2$.

Mais il convient de noter que le procédé et la source, objets de la présente invention, utilisent une cible de faible épaisseur, comprise dans l'intervalle allant d'environ 0,05 µm à environ 5 µm, cette cible étant faite, de préférence, d'un matériau dont le numéro atomique Z est très supérieur à celui de l'aluminium, puisque Z est de préférence supérieur ou égal à 28 (et inférieur ou égal à 92).

On précise que le matériau préféré pour former la cible utilisée dans la présente invention est l'étain pour lequel Z vaut 50.

De plus, dans l'invention, on peut utiliser une cible de très faible épaisseur, inférieure ou égale à 1 µm, formée sur un substrat en matière plastique (par exemple un substrat de $CH_2$ (polyéthylène) de 1 µm d'épaisseur), la face arrière de cette cible (de préférence en étain) - face qui émet le rayonnement EUV utilisé - reposant sur ce substrat. Il est également possible de former, sur la face avant de cette cible, une couche d'or dont l'épaisseur est inférieure à 100 nm (c'est-à-dire 1000 Å).

En revenant à l'article mentionné plus haut, il convient de noter que la cible d'aluminium de 7 µm d'épaisseur n'est pas envisageable pour une émission par sa face arrière lorsqu'on irradie sa face avant par un rayonnement laser de densité de puissance maximale inférieure aux 3 x $10^{13}$ W/cm$^2$ mentionnés dans l'article, et ce, en particulier dans le domaine de la microlithographie, la densité de puissance maximale considérée ci-dessus étant par exemple voisine de $10^{12}$ W/cm$^2$.

Il convient également de noter ce qui suit :

Lorsque l'interaction laser a lieu sur un matériau de numéro atomique Z faible, comme l'aluminium (Z=13), le transport de l'énergie laser absorbée dans la couronne (du côté où le laser interagit, c'est-à-dire la face avant) vers les zones denses et froides (c'est-à-dire vers la face arrière) se fait par conduction thermique électronique. Même dans le cas où la cible est relativement épaisse comme celle proposée dans l'article mentionné plus haut, l'obtention d'une émission anisotrope en face arrière n'est pas du tout garantie.

Par contre, dans le cas d'un matériau de Z élevé, c'est la conduction radiative qui régit la mise en condition de l'intérieur et de l'arrière de la cible. L'anisotropie qui fait tout l'intérêt de la présente invention est directement liée au débouché de cette onde radiative en face arrière, donc au choix d'une épaisseur, dont une valeur optimisée sera donnée dans ce qui suit.

Les profils caractéristiques de températures et de densité électronique dans la cible irradiée par laser sont d'ailleurs très différents suivant que le matériau est de numéro atomique faible ou élevé et également suivant l'épaisseur de la cible utilisée.

Un modèle analytique permet de trouver l'épaisseur optimale $E_0$ qui permet d'optimiser le taux de conversion X en face arrière. $E_0$ est reliée au numéro atomique Z du matériau de la cible, à la masse atomique A de ce matériau, à la température T (en K) dans le milieu (elle-même reliée au flux laser absorbé $\varphi_a$, exprimé en W/cm$^2$), à la longueur d'onde $\lambda$ du laser (en µm), à la durée d'impulsion Dt (en secondes) et à la densité massique $\rho$ (g/cm$^3$) par la formule suivante :

$$E_0 \text{ (en cm)} = 26{,}22 \, (A/Z)^{0,5} \times T^{0,5} \times D_t/\alpha$$

avec

$$\alpha = \rho \times \lambda^2 \times [1+0{,}946 \, (A/Z)^{0,5}]$$

La température (en K) est proportionnelle à $\varphi_a^{2/3}$ et à $\lambda^{4/3}$.

Pour une énergie laser disponible faible (inférieure à 1J), ce qui est généralement nécessaire dans le cadre des applications de l'invention à la lithographie, car une très forte cadence (supérieure à 1 kHz) est demandée pour réaliser une statistique suffisante au niveau de la résine photosensible (et garantir ainsi que le seuil d'insolation est atteint), et une taille de zone émissive (imposée par un couplage optimum avec le système optique utilisé) donnée (par exemple proche de 300 µm de diamètre), le flux laser tombant sur la cible est faible. En régime nanoseconde, il ne dépasse pas $10^{12}$ W/cm$^2$ à 1,06 µm. De plus, à l'heure actuelle, il n'est pratiquement pas envisageable de fabriquer des lasers à ces cadences reposant sur un train d'impulsions de 100 ps.

Dans ces conditions, le modèle ci-dessus donne, comme température de milieu qu'il est possible d'atteindre si toute l'énergie est absorbée, une valeur de 30 eV.

Dans ces conditions, pour l'aluminium, l'épaisseur optimale qui optimise le taux de conversion X en face arrière vaut 0,15 µm, ce qui est très éloigné des conditions données dans l'article mentionné plus haut. De plus, avec un matériau tel que l'aluminium, de numéro atomique faible, le rayonnement émis par la face arrière de la cible ne présente pas, a priori, de particularité angulaire : il est sensiblement isotrope ; face avant et face arrière peuvent donc être considérées comme équivalentes.

Dans le cas de l'or, on trouve, toujours dans les mêmes conditions, moins de 0,1 µm.

En revenant à l'exemple donné plus haut d'une cible en étain, formée sur un substrat en $CH_2$ (polyéthylène), on donne les précisions suivantes : le polyéthylène, que l'on peut mettre sur la face arrière d'une mince feuille d'étain, et l'or que l'on peut mettre sur la face avant de cette feuille, servent tous deux à limiter l'expansion du matériau émetteur constitué par l'étain avant son chauffage par l'onde radiative, ceci de façon à mieux faire pénétrer les photons dans la zone d'intérêt de la cible. Le polyéthylène en face arrière, qui est légèrement chauffé, est transparent au rayonnement, limite également la détente et donc un petit peu l'émission de débris de matière.

## Revendications

**1.** Procédé d'obtention de rayonnement électromagnétique dans la bande ultraviolette extrême, procédé selon lequel on utilise au moins une cible solide (28, 42), ayant une première et une seconde faces, cette cible étant capable d'émettre un rayonnement électromagnétique dans la bande ultraviolette extrême par interaction avec un faisceau laser (34), lorsque l'on focalise ce faisceau laser sur la première face (30) de la cible, procédé **caractérisé en ce que** la cible (28, 42) contient. un matériau qui est capable d'émettre le rayonnement électromagnétique dans la bande ultraviolette extrême par interaction avec le faisceau laser, et **en ce que** l'épaisseur de la cible est comprise dans un intervalle allant d'environ 0,05 µm à environ 5 µm, la cible étant capable d'émettre à partir de sa seconde face (37), de façon anisotrope, une partie (36) du rayonnement électromagnétique dans la bande ultraviolette extrême, et **en ce qu'**on collecte et on transmet cette partie du rayonnement électromagnétique dans la bande ultraviolette extrême en vue d'une utilisation.

**2.** Source de rayonnement électromagnétique dans la bande ultraviolette extrême, cette source comprenant au moins une cible solide (28, 42), ayant une première et une seconde faces, cette cible étant capable émettre un rayonnement électromagnétique dans la bande ultraviolette extrême par interaction avec un faisceau laser (34) focalisé sur la première face (30) de la cible, cette source étant **caractérisée en ce que** la cible (28, 42) contient un matériau qui est capable d'émettre le rayonnement électromagnétique dans la bande ultraviolette éxtrême par interaction avec le faisceau laser, et **en ce que** l'épaisseur de la cible est comprise dans un intervalle allant environ 0,05 µm à environ 5 µm, la cible étant capable d'émettre à partir de sa seconde face (37), de façon anisotrope, une partie (36) du rayonnement électromagnétique dans la bande ultraviolette extrême, cette partie du rayonnement électromagnétique dans la bande ultraviolette extrême étant collectée et transmise en vue d'une utilisation.

**3.** Source selon la revendication 2, dans laquelle le numéro atomique du matériau contenu dans la cible appartient à l'ensemble des numéros atomiques allant de 28 à 92.

**4.** Source selon l'une quelconque des revendications 2 et 3, comprenant une pluralité de cibles (42) qui sont rendues solidaires les unes des autres, la source comprenant en outre des moyens (48, 50) de déplacement de cette pluralité de cibles pour que ces cibles reçoivent successivement le faisceau laser (34).

**5.** Source selon la revendication 4, comprenant en outre des moyens de support (38, 44, 52) auxquels sont fixées les cibles (42) et qui sont capables de laisser passer le faisceau laser en direction de ces cibles, les moyens de déplacement (48, 50) étant prévus pour déplacer ces moyens de support et donc les cibles.

**6.** Source selon la revendication 5, dans laquelle les moyens de support (52) sont capable d'absorber des rayonnements émis par la première face de chaque cible qui reçoit le faisceau laser et à réémettre ces rayonnements vers cette cible.

**7.** Source selon l'une quelconque des revendications 5 et 6, dans laquelle les moyens de support comprennent une ouverture (40, 46) en regard de chaque cible, cette ouverture étant délimitée par deux parois (54, 56) sensiblement parallèles l'une par rapport à l'autre et perpendiculaires à cette cible.

**8.** Source selon l'une quelconque des revendications 5 et 6, dans laquelle les moyens de support comprennent une ouverture en regard de chaque cible, cette ouverture étant délimitée par deux parois (55, 57) qui vont vers la cible en s'écartant l'une de l'autre.

9. Source selon l'une quelconque des revendications 2 à 5, comprenant en outre des moyens auxiliaires fixes (58) qui sont capables de laisser passer le faisceau laser (34) en direction de la cible, d'absorber des rayonnements émis par la première face de cette cible et de réémettre ces rayonnements vers cette cible.

10. Dispositif de lithographie comprenant :

   - un support (16) supportant un échantillon qui est destiné à être insolé suivant un motif déterminé,
   - une source (22) de rayonnement électromagnétique dans la bande ultraviolette extrême selon l'une quelconque des revendications 2 à 9,
   - un masque (24) comprenant le motif déterminé sous une forme agrandie,
   - des moyens optiques (26) de collection et de transmission, au masque, de la partie du rayonnement électromagnétique dans la bande ultraviolette extrême provenant de la seconde face de la cible illuminée par le faisceau laser de la source, le masque étant ainsi capable de fournir une image du motif sous forme agrandie, et
   - des moyens optiques (29) de réduction de cette image et de projection de l'image réduite sur l'échantillon.

11. Dispositif selon la revendication 10, dans lequel l'échantillon comprend un substrat semiconducteur (18) sur lequel est déposée une couche (20) de résine photosensible qui est destinée à être insolée suivant le motif déterminé.


**Patentansprüche**

1. Verfahren zur Erzeugung einer elektromagnetischen Strahlung in dem extrem-ultravioletten Band, wobei man bei diesem Verfahren wenigstens ein Festkörper-Target (28, 42) mit einer ersten und einer zweiten Fläche benutzt und dieses Target fähig ist, durch Wechselwirkung mit einem Laserstrahl (34) eine elektromagnetische Strahlung in dem extrem-ultravioletten Band abzustrahlen, wenn man diesen Laserstrahl auf die erste Fläche (30) des Targets fokussiert, und dieses Verfahren dabei **dadurch gekennzeichnet ist, dass** das Target (28, 42) ein Material enthält, das fähig ist, die elektromagnetische Strahlung in dem extrem-ultravioletten Band durch Wechselwirkung mit dem Laserstrahl abzustrahlen, und dadurch, dass die Dicke des Targets in einem Intervall enthalten ist, das von ungefähr 0,05 µm bis ungefähr 5 µm geht, das Target fähig ist, einen Teil (36) der elektromagnetischen Strahlung in dem extrem-ultravioletten Band in anisotroper Weise von seiner zweiten Fläche (37) abzustrahlen, und dadurch, dass man diesen Teil der elektromagnetischen Strahlung des extrem-ultravioletten Bands sammelt und hinsichtlich einer Nutzung überträgt

2. Quelle für elektromagnetische Strahlung in dem extrem-ultravioletten Band, wobei diese Quelle wenigstens ein Festkörper-Target (28, 42) mit einer ersten und einer zweiten Fläche umfasst und dieses Target fähig ist, durch Wechselwirkung mit einem auf die erste Fläche (30) des Targets fokussierten Laserstrahl (34) eine elektromagnetische Strahlung in dem extrem-ultravioletten Band abzustrahlen, und diese Quelle dabei **dadurch gekennzeichnet ist, dass** das Target (28, 42) ein Material enthält, das fähig ist, die elektromagnetische Strahlung in dem extrem-ultravioletten Band durch Wechselwirkung mit dem Laserstrahl abzustrahlen, und dadurch, dass die Dicke des Targets in einem Intervall enthalten ist, das von ungefähr 0,05 µm bis ungefähr 5 µm geht, das Target fähig ist, einen Teil (36) der elektromagnetischen Strahlung in dem extrem-ultravioletten Band in anisotroper Weise von seiner zweiten Fläche (37) abzustrahlen, wobei dieser Teil der elektromagnetischen Strahlung des extrem-ultravioletten Bands gesammelt und hinsichtlich einer Nutzung übertragen wird.

3. Quelle nach Anspruch 2, bei der die Atomnummer des in dem Target enthaltenen Materials zu der Gruppe der Atomnummern gehört, die von 28 bis 92 geht.

4. Quelle nach einem der Ansprüche 2 und 3, eine Vielzahl von Targets (42) umfassend, die miteinander verbunden sind, wobei die Quelle außerdem Einrichtungen (48, 50) zur Verschiebung dieser Vielzahl von Targets umfasst, so dass diese Targets den Laserstrahl (34) nacheinander empfangen.

5. Quelle nach Anspruch 4, außerdem eine Vielzahl Trägereinrichtungen (38, 44, 52) umfassend, an denen die Targets (42) befestigt sind und die so konzipiert sind, dass sie den Laserstrahl in Richtung dieser Targets durchlassen, wobei die Verschiebungseinrichtungen (48, 50) dazu dienen, diese Trägereinrichtungen und folglich diese Targets zu verschieben.

6. Quelle nach Anspruch 5, bei der die Trägereinrichtungen (52) fähig sind, Strahlen zu absorbieren, die durch die den Laserstrahl empfangende erste Fläche jedes Targets abgestrahlt werden, und diese Strahlen in Richtung dieses Targets wieder abzustrahlen.

**7.** Quelle nach einem der Ansprüche 5 und 6, bei der die Trägereinrichtungen vor jedem Target eine Öffnung (40, 46) umfassen, wobei diese Öffnung abgegrenzt wird durch zwei Wände (54, 56), die im Wesentlichen parallel zueinander und senkrecht zu diesem Target sind.

**8.** Quelle nach einem der Ansprüche 5 und 6, bei der die Trägereinrichtungen vor jedem Target eine durch zwei Wände (55, 57) abgegrenzte Öffnung umfassen, wobei diese Öffnung sich in Richtung Target erweitert.

**9.** Quelle nach einem der Ansprüche 2 bis 5, außerdem zusätzliche feste Einrichtungen (58) umfassend, die fähig sind, den Laserstrahl (34) in Richtung Target durchzulassen, durch die erste Fläche dieses Targets abgestrahlte Strahlen zu absorbieren und diese Strahlen wieder abzustrahlen in Richtung dieses Targets.

**10.** Lithografie-Vorrichtung, umfassend:

- einen Träger (16), der dazu dient, ein Musterteil zu tragen, das gemäß einem festgelegten Muster bestrahlt werden soll,
- eine Quelle (22) für elektromagnetische Strahlung in dem extrem-ultravioletten Band nach einem der Ansprüche 2 bis 9,
- eine Maske (24), die das festgelegte Muster in einer vergrößerten Form umfasst,
- optische Einrichtungen (26) zum Sammeln und zum Übertragen des Teils der elektromagnetischen Strahlung des extrem-ultravioletten Bands, der von der von dem Laserstrahl der Quelle bestrahlten zweiten Fläche des Targets stammt, wobei die Maske infolgedessen fähig ist, ein Bild des Musters in vergrößerter Form zu tiefem, und
- optische Einrichtungen (29) zum Reduzieren dieses Bilds und zum Projizieren des reduzierten Bilds auf das Musterteil.

**11.** Vorrichtung nach Anspruch 10, bei dem das Musterteil ein Halbleitersubstrat (18) umfasst, auf dem eine Fotoresistschicht (20) abgeschieden ist, die dazu bestimmt ist, gemäß dem festgelegten Muster bestrahlt zu werden.

## Claims

**1.** Method for obtaining extreme electromagnetic radiation in the ultraviolet range, method according to which at least one solid target (28, 42) is used, having a first and a second face, said target being able to emit extreme electromagnetic radiation in the ultraviolet range by interaction with a laser beam (34), when said laser beam is focussed on the first face (30) of the target, **characterized in that** the target (28, 42) contains material which is able to emit the extreme electromagnetic radiation in the ultraviolet range by interaction with the laser beam, and **in that** the thickness of the target is in a range from about 0.05 $\mu$m to about 5 $\mu$m, the target being able to anisotropically emit from its second face (37) a portion (36) of the extreme electromagnetic radiation in the ultraviolet range, and **in that** this portion of extreme electromagnetic radiation in the ultraviolet range is collected and transmitted with a view to use.

**2.** Source of extreme electromagnetic radiation in the ultraviolet range, said source comprising at least one solid target (28, 42), having a first and a second face, said target being able to emit extreme electromagnetic radiation in the ultraviolet range by interaction with a laser beam (34) focussed on the first face (30) of the target, wherein this source is **characterized in that** the target (28, 42) contains material which is able to emit extreme electromagnetic radiation in the ultraviolet range by interaction with the laser beam, and **in that** the thickness of the target is in a range from about 0.05 $\mu$m to about 5 $\mu$m, the target being able to anisotropically emit from its second face (37) a portion (36) of the extreme electromagnetic radiation in the ultraviolet range, wherein this portion of extreme electromagnetic radiation in the ultraviolet range is collected and transmitted with a view to use.

**3.** Source according to claim 2, wherein the atomic number of the material contained in the target belongs to the set of atomic numbers from 28 to 92.

**4.** Source according to any of the claims 2 and 3, comprising a plurality of targets (42) which are securely fixed to one another, wherein the source further comprises means (48, 50) for moving this plurality of targets so that these targets successively receive the laser beam (34).

**5.** Source according to claim 4, further comprising support means (38, 44, 52) to which targets (42) are fixed and which are able to let the laser beam pass through in the direction of these targets, wherein moving means (48, 50) are provided for moving these support means and thereby the targets.

**6.** Source according to claim 5, wherein the support means (52) are able to absorb radiations emitted by the first face of each target which receives the laser beam and to re-emit these radiations towards this target.

**7.** Source according to any of claims 5 and 6, wherein the support means comprise an aperture (40, 46) facing each target, wherein this aperture is delimited by two walls (54, 56) substantially parallel to one another and perpendicular to this target.

8. Source according to any of claims 5 and 6, wherein the support means comprise an aperture facing each target, wherein this aperture is delimited by two walls (55, 57) which run towards the target and away from one another.

9. Source according to any of claims 2 to 5, further comprising fixed auxiliary means (58) which are able to let the laser beam (34) pass through in the direction of the target, to absorb the radiations emitted by the first face of this target and to re-emit these radiations towards this target.

10. Lithography device comprising:

   - a support (16) supporting a sample to be insolated according to a predetermined pattern,
   - a source (22) of extreme electromagnetic radiation in the ultraviolet range according to any of claims 2 to 9,
   - a mask (24) comprising the determined pattern in an enlarged form,
   - optical means (26) for collecting and transmitting, to the mask, the portion of extreme electromagnetic radiation in the ultraviolet range from the second face of the target illuminated by the laser beam of the source, wherein the mask is thus able to provide an image of the pattern in an enlarged form, and
   - optical means (29) for reducing this image and for projecting the reduced image on the sample.

11. Device according to claim 10, wherein the sample comprises a semiconductor substrate (18) whereon is coated a layer (20) of photosensitive resin which is to be insolated according to the determined pattern.

EP 1 230 828 B1

FIG. 1

FIG. 2

12

EP 1 230 828 B1

FIG. 3

FIG. 4

13

FIG. 5

FIG. 6